# EUROPEAN PATENT APPLICATION

(11) **EP 4 851 641 A1**
(43) Date of publication of application: **09.12.2026**
(21) Application number: 25924197.4
(22) Date of filing: 07.11.2025
(51) Int. Cl.: G01R 31/14, G01R 27/02, G01R 31/392, G01R 31/389, G01R 31/56, G01R 15/04, G01R 1/20

(54) **INSULATION RESISTANCE MEASUREMENT DEVICE AND BATTERY SYSTEM**

(30) Priority: 04.02.2025 KR 20250013988
(71) Applicant: LG Energy Solution, Ltd., Seoul 07335 (KR)
(72) Inventor: CHOI, Jang Hyeok, Daejeon 34122 (KR)
(74) Representative: Plasseraud IP
(86) International application number: PCT/KR2025/018301
(87) International publication number: WO 2026/168681

(57) **Abstract**

A battery system includes: a first insulation resistance monitoring circuit configured to provide a first voltage divided by a first resistor and a second resistor between a positive terminal of a battery pack connected to a load and a ground terminal; a second insulation resistance monitoring circuit configured to provide a second voltage divided by a third resistor and a fourth resistor between the ground terminal and a negative terminal of the battery pack; a third insulation resistance monitoring circuit configured to provide a third voltage divided by a fifth resistor and a sixth resistor between a first terminal of the load and the ground terminal; a fourth insulation resistance monitoring circuit configured to provide a fourth voltage divided by a seventh resistor and an eighth resistor between the ground terminal and a second terminal of the load; and a main control unit (MCU) configured to diagnose an insulation state of the load using the third voltage and the fourth voltage, and to diagnose an insulation state of the battery pack using the first voltage and the second voltage.

## Description

### CROSS-REFERENCE TO RELATED APPLICATION

This application claims priority to and the benefit of Korean Patent Application No. 10-2025-0013988 filed with the Korean Intellectual Property Office on February 4, 2025, the entire contents of which are incorporated herein by reference.

The present disclosure relates to an insulation resistance measurement apparatus and a battery system.

### [Background]

Electric vehicles may be driven using an electric motor. Electric vehicles use a battery pack, which is a high-voltage power source, to drive the electric motor. Battery packs are also used in various external devices in addition to electric vehicles.

In external devices using a battery pack, it is necessary to maintain good insulation state between the battery pack and the external device. If the insulation state of the battery pack is not maintained, leakage current occurs. Leakage current of the battery pack may cause unexpected discharge of the battery pack or malfunctions of electrical components provided in the external device and may cause fatal electric shock to humans. Therefore, a battery management system (BMS) that manages a battery pack includes an insulation resistance measurement apparatus having an insulation diagnosis function.

Generally, an insulation resistance measurement circuit is provided at the battery pack part. In this case, if a relay connecting the battery pack and an external device is open, the insulation resistance of the external device cannot be checked.

In addition, a Y-capacitor may be connected to an electrical component (e.g., an inverter) of an external device to remove high-frequency noise from the power input from the battery pack. When an unexpected situation such as a momentary power supply occurs, high voltage may be charged in the Y-capacitor. If the voltage charged in the Y-capacitor remains without being discharged, the risk of electric shock increases when a body of user comes into contact with a grounded part during maintenance work or use of the external device.

### [Summary]

An embodiment of the present disclosure is to provide an insulation resistance measurement apparatus and a battery system capable of measuring the insulation resistance of a load regardless of whether a relay connecting a battery pack and an external device is turned on or off.

According to one embodiment, a battery system may be provided. The battery system includes a battery pack connected to a load of an external device, a first insulation resistance monitoring circuit configured to include a first resistor, a first switch, and a second resistor connected in series between a positive terminal of the battery pack and a ground terminal, and to provide a first voltage divided by the first resistor and the second resistor, a second insulation resistance monitoring circuit configured to include a first DC voltage source, a third resistor, a second switch, and a fourth resistor connected in series between the ground terminal and a negative terminal of the battery pack, and to provide a second voltage divided by the third resistor and the fourth resistor, a first relay positioned between the positive terminal of the battery pack and a first terminal of the load, a second relay positioned between the negative terminal of the battery pack and a second terminal of the load, a first capacitor connected between the first terminal of the load and the second terminal of the load, a third insulation resistance monitoring circuit configured to include a fifth resistor, a third switch, and a sixth resistor connected in series between the first terminal of the load and the ground terminal, and to provide a third voltage divided by the fifth resistor and the sixth resistor, a fourth insulation resistance monitoring circuit configured to include a second DC voltage source, a seventh resistor, a fourth switch, and an eighth resistor connected in series between the ground terminal and the second terminal of the load, and to provide a fourth voltage divided by the seventh resistor and the eighth resistor, and a main control unit (MCU) configured to diagnose an insulation state of the load using the third voltage and the fourth voltage, and to diagnose an insulation state of the battery pack using the first voltage and the second voltage.

The battery system may further include a second capacitor connected between the first terminal of the load and the ground terminal, and a third capacitor connected between the ground terminal and the second terminal of the load, wherein, in an on-state of the first relay and the second relay, the MCU may diagnose the insulation state of the load using the third voltage and the fourth voltage, when the insulation state of the load is determined to be a symmetric insulation breakdown, the MCU may diagnose the insulation state of the battery pack using the first voltage and the second voltage, and when the insulation state of the battery pack is determined to be an insulation breakdown, the MCU may transition the first relay and the second relay to an off-state, turn on the third switch and the fourth switch, and discharge the second capacitor and the third capacitor.

The MCU may measure a first insulation resistance formed between the first terminal of the load and the ground terminal and a second insulation resistance formed between the ground terminal and the second terminal of the load using the third voltage and the fourth voltage, and when both the first insulation resistance and the second insulation resistance are less than a reference value, the MCU may determine the insulation state of the load to be the symmetric insulation breakdown.

When the insulation state of the load is determined to be an asymmetric insulation breakdown, the MCU may transition the first relay and the second relay to the off-state, turn on the third switch and the fourth switch, discharge the second capacitor and the third capacitor, and re-diagnose the insulation state of the load using the third voltage and the fourth voltage.

When the insulation state of the load according to the re-diagnosis is an asymmetric insulation breakdown, the MCU may diagnose the insulation state of the battery pack using the first voltage and the second voltage, and diagnose a final insulation breakdown based on the insulation state of the battery pack.

The MCU may determine the insulation state of the load as the asymmetric insulation breakdown when either the first insulation resistance or the second insulation resistance is less than the reference value.

The MCU periodically performs an operation of simultaneously turning on the first and third switches and simultaneously turning on the second and fourth switches to periodically receive the first voltage, the second voltage, the third voltage, and the fourth voltage.

The MCU may periodically perform an operation of simultaneously turning on the first and third switches and simultaneously turning on the second and fourth switches to periodically receive the first voltage, the second voltage, the third voltage, and the fourth voltage.

The MCU may periodically perform an operation of turning on the first switch, the second switch, the third switch, and the fourth switch one by one for a predetermined period to periodically receive the first voltage, the second voltage, the third voltage, and the fourth voltage.

According to another embodiment, an insulation resistance measurement apparatus of a battery management system for managing a battery pack connected to a load of an external device may be provided. The insulation resistance measurement apparatus may include a first monitoring circuit configured to measure a first voltage divided by a first resistor and a second resistor connected in series between a positive terminal of the battery pack and a ground terminal, and a second voltage divided by a third resistor and a fourth resistor connected in series between the ground terminal and a negative terminal of the battery pack, a first relay connected between the positive terminal of the battery pack and a positive connection terminal of the battery pack connected to a first terminal of the load, a second relay connected between the negative terminal of the battery pack and a negative connection terminal of the battery pack connected to a second terminal of the load, a first capacitor connected between the first terminal of the load and the second terminal of the load, a second monitoring circuit configured to measure a third voltage divided by a fifth resistor and a sixth resistor connected in series between the positive connection terminal of the battery pack and the ground terminal, and a fourth voltage divided by a seventh resistor and an eighth resistor connected in series between the ground terminal and the negative connection terminal of the battery pack, and a main control unit (MCU) configured to measure a first insulation resistance formed between the positive terminal of the battery pack and the ground terminal and a second insulation resistance formed between the ground terminal and the negative terminal of the battery pack using the first voltage and the second voltage, and to measure a third insulation resistance formed between the first terminal of the load and the ground terminal and a fourth insulation resistance formed between the ground terminal and the second terminal of the load using the third voltage and the fourth voltage.

The first monitoring circuit may further include a first switch connected between the positive terminal of the battery pack and the ground terminal on a path formed by the first resistor and the second resistor, and a first DC voltage source and a second switch connected between the ground terminal and the negative terminal of the battery pack on a path formed by the third resistor and the fourth resistor, wherein the second monitoring circuit may further include a third switch connected between the positive connection terminal of the battery pack and the ground terminal on a path formed by the fifth resistor and the sixth resistor, and a second DC voltage source and a fourth switch connected between the ground terminal and the negative connection terminal of the battery pack on a path formed by the seventh resistor and the eighth resistor, and wherein, in an on-state of the first relay and the second relay, the MCU may diagnose an insulation state of the load based on the third insulation resistance and the fourth insulation resistance, when the insulation state of the load is determined to be a symmetric insulation breakdown, the MCU may diagnose an insulation state of the battery pack based on the first insulation resistance and the second insulation resistance, and when the insulation state of the battery pack is determined to be an insulation breakdown, the MCU may transition the first relay and the second relay to an off-state, turn on the third switch and the fourth switch, and discharge a second capacitor connected between the first terminal of the load and the ground terminal and a third capacitor connected between the ground terminal and the second terminal of the load.

The MCU may measure a voltage of the battery pack, determines a reference value for insulation state diagnosis based on the voltage of the battery pack, and determine the insulation state of the load as the symmetric insulation breakdown when both the third insulation resistance and the fourth insulation resistance are less than the reference value.

When the insulation state of the load is determined to be an asymmetric insulation breakdown, the MCU may transition the first relay and the second relay to the off-state, turn on the third switch and the fourth switch, discharge the second capacitor and the third capacitor, and re-diagnose the insulation state of the load using the third voltage and the fourth voltage.

When the insulation state of the load according to the re-diagnosis is an asymmetric insulation breakdown, the MCU may diagnose the insulation state of the battery pack using the first voltage and the second voltage, and diagnose a final insulation breakdown based on the insulation state of the battery pack.

The MCU may determine the insulation state of the load as the asymmetric insulation breakdown when either the third insulation resistance or the fourth insulation resistance is less than the reference value.

The MCU may periodically perform an operation of simultaneously turning on the first and third switches and simultaneously turning on the second and fourth switches to periodically receive the first voltage, the second voltage, the third voltage, and the fourth voltage.

The MCU may periodically perform an operation of turning on the first switch, the second switch, the third switch, and the fourth switch one by one for a predetermined period to periodically receive the first voltage, the second voltage, the third voltage, and the fourth voltage.

According to at least one of the embodiments, the insulation resistance of a load may be measured regardless of whether a relay connecting a battery pack and an external device is turned on or off.

In addition, according to at least one of the embodiments, when an insulation breakdown of the load and an insulation breakdown of the battery pack occur, a Y-capacitor connected between the load and a ground is discharged, thereby preventing the risk of electric shock during maintenance work.

Furthermore, according to at least one of the embodiments, in the event of an asymmetric insulation breakdown of the load, the insulation state diagnosis accuracy may be improved by discharging the Y-capacitor connected between the load and the ground and re-diagnosing the insulation state of the load.

### [Description of the Drawings]

FIG. 1 is a diagram illustrating an example of an external device using a battery system according to an embodiment.
FIG. 2 is a diagram illustrating an example of the first to fourth insulation resistance monitoring circuits and the voltage monitoring circuit shown in FIG. 1.
FIG. 3 is a diagram illustrating an example of switch timing for insulation resistance measurement according to an embodiment.
FIG. 4 is a diagram illustrating the voltage of a first insulation resistance monitoring terminal when a first switch is turned on while a first relay and a second relay shown in FIG. 2 are in an off state.
FIG. 5 is a diagram illustrating the voltage of a second insulation resistance monitoring terminal when a second switch is turned on while the first relay and the second relay shown in FIG. 2 are in an off state.
FIG. 6 is a diagram illustrating the voltages of the first and third insulation resistance monitoring terminals when the first switch and a third switch are turned on while the first relay and the second relay shown in FIG. 2 are in an on state.
FIG. 7 is a diagram illustrating the voltages of the second and fourth insulation resistance monitoring terminals when the second switch and a fourth switch are turned on while the first relay and the second relay shown in FIG. 2 are in an on state.
FIGS. 8 to 10 are flowcharts illustrating an insulation state diagnosis method when the first relay and the second relay transition from an off state to an on state according to an embodiment.
FIG. 11 is a flowchart illustrating an insulation state diagnosis method when the first relay and the second relay transition from an on state to an off state according to an embodiment.

### [Detailed Description]

Hereinafter, embodiments will be described in detail with reference to the accompanying drawings so that those skilled in the art to which the present invention pertains can easily implement them. However, they may be implemented in various different forms and is not limited to the embodiments described herein. The drawings and description are to be regarded as illustrative in nature and not restrictive. Like reference numerals designate like elements throughout the specification. In the flowchart described with reference to the drawings in this specification, the order of operations may be changed, several operations may be merged, some operations may be divided, and specific operations may not be performed.

Unless explicitly described to the contrary, the word "comprise", and variations such as "comprises" or "comprising", will be understood to imply the inclusion of stated elements but not the exclusion of any other elements. Throughout the specification and claims, if a part is referred to "include" a certain element, it may mean that it may further include other elements rather than exclude other elements, unless specifically indicated otherwise.

In addition, expressions described in the singular may be interpreted in the singular or plural unless explicit expressions such as "one" or "single" are used.

In addition, terms including an ordinal number, such as first, second, etc., may be used to describe various elements, but the elements are not limited by the terms. The above terms are used only for the purpose of distinguishing one element from another element. For example, without departing from the scope of the present disclosure, a first element may be referred to as a second element, and similarly, a second element may be referred to as a first element.

Furthermore, if a component is referred to be "connected" with another component, it includes not only the case where two components are "directly connected" but also the case where two components are "indirectly or non-contactedly connected" with another component interposed therebetween, or the case where two components are "electrically connected." On the other hand, if an element is referred to as "directly connected" to another element, it should be understood that no other element exists in the middle.

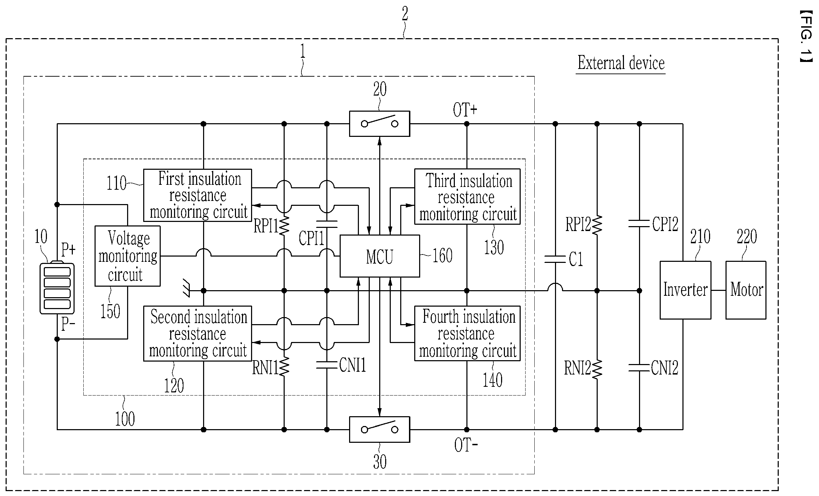

FIG. 1 is a diagram illustrating an example of an external device using a battery system according to an embodiment.

Referring to FIG. 1, an external device 2 may be driven using a battery system 1.

The battery system 1 may have a structure connected to a load of the external device 2 through a positive connection terminal OT+ and a negative connection terminal OT-.

The battery system 1 may operate as a power source that supplies power to the load and may be discharged.

In some embodiments, the external device 2 may be, for example, an electronic device, a means of transportation, or an energy storage system (ESS). The means of transportation may be a vehicle such as an electric vehicle, a hybrid electric vehicle, or a smart mobility device.

In an embodiment, when the external device 2 is a vehicle, the load may include an inverter 210 and a motor 220.

The inverter 210 may be connected between the positive connection terminal OT+ and the negative connection terminal OT- of the battery system 1, and may convert DC power supplied from the battery pack 10 of the battery system 1 into AC power, and supply the AC power to the motor 220.

In addition, a capacitor C1 may be connected between the positive connection terminal OT+ and the negative connection terminal OT- of the battery system 1. The capacitor C1 may remove noise from the DC power output from the battery system 1.

The motor 220 may be driven using the AC power from the inverter 210. For example, a three-phase AC motor may be used as the electric motor 220. Components within the vehicle that receive discharge power from the battery pack 10, including the inverter 210 and the motor 220, may be collectively referred to as an electrical load.

The battery system 1 may include a battery pack 10, a first relay 20, a second relay 30, and an insulation resistance measurement apparatus 100. The battery system 1 includes a battery management system (BMS) that manages the battery pack 10, and the insulation resistance measurement apparatus 100 may be implemented within the BMS. In this case, the BMS may be referred to as the insulation resistance measurement apparatus 100.

The battery pack 10 may include a plurality of battery cells connected in series. The plurality of battery cells are capable of charging and discharging, and the number of battery cells and their connection relationship may be designed according to the voltage and capacity required for the battery pack 10.

The first relay 20 and the second relay 30 may provide a current path during charging and discharging of the battery pack 10.

The first relay 20 may be connected between a positive terminal P+ of the battery pack 10 and the positive connection terminal OT+ of the battery system 1.

The second relay 30 may be connected between a negative terminal P- of the battery pack 10 and the negative connection terminal OT- of the battery system 1.

The first relay 20 and the second relay 30 may be turned on or off in response to control signals from a main control unit (MCU) 160, and may control the connection between the battery pack 10 and the external device 2. When the first relay 20 and the second relay 30 are closed, the positive terminal P+ of the battery pack 10 is electrically connected to the positive connection terminal OT+ of the battery system 1, and the negative terminal P- of the battery pack 10 is electrically connected to the negative connection terminal OT- of the battery system 1.

The first relay 20 and the second relay 30 may be mechanical contactors turned on/off by the magnetic force of a coil, or semiconductor switches such as metal oxide semiconductor field effect transistors (MOSFETs).

An insulation resistance RPI1 and a Y-capacitor CPI1 of the battery system 1 may be formed between the positive terminal P+ of the battery pack 10 and a ground terminal of the external device 2. An insulation resistance RNI1 and a Y-capacitor CNI1 of the battery system 1 may be formed between the negative terminal P- of the battery pack 10 and the ground terminal of the external device 2. The Y-capacitors CPI1 and CNI1 may remove high-frequency noise components of the power input to the battery pack 10.

Furthermore, an insulation resistance RPI2 and a Y-capacitor CPI2 of the external device 2 may be formed between the positive connection terminal OT+ of the battery system 1 and the ground terminal of the external device 2. An insulation resistance RNI2 and a Y-capacitor CNI2 of the external device 2 may be formed between the negative connection terminal OT- of the battery system 1 and the ground terminal of the external device 2. The ground terminal of the external device 2 may be, for example, a chassis of a vehicle. The Y-capacitors CPI2 and CNI2 may remove high-frequency noise components of the power input to the external device 2.

The insulation resistance measurement apparatus 100 may measure the voltage and the insulation resistances RPI1, RNI1, RPI2, and RNI2 of the battery pack 10. That is, the insulation resistance measurement apparatus 100 may measure not only the insulation resistances RPI1 and RNI1 of the battery system 1 but also the insulation resistances RPI2 and RNI2 of the external device 2.

The insulation resistance measurement apparatus 100 may include a first insulation resistance monitoring circuit 110, a second insulation resistance monitoring circuit 120, a third insulation resistance monitoring circuit 130, a fourth insulation resistance monitoring circuit 140, a voltage monitoring circuit 150, and an MCU 160.

The first insulation resistance monitoring circuit 110 may be connected between the positive terminal P+ of the battery pack 10 and the ground terminal of the external device 2, and may output a first voltage corresponding to the voltage difference between the positive terminal P+ of the battery pack 10 and the ground terminal of the external device 2 to the MCU 160. For example, the voltage difference between the positive terminal P+ of the battery pack 10 and the ground terminal of the external device 2 is divided using a plurality of resistors, and the voltage divided by the plurality of resistors may be used as the first voltage.

The second insulation resistance monitoring circuit 120 may be connected between the ground terminal of the external device 2 and the negative terminal P- of the battery pack 10, and may output a second voltage corresponding to the voltage difference between the ground terminal of the external device 2 and the negative terminal P- of the battery pack 10 to the MCU 160. For example, the voltage difference between the ground terminal of the external device 2 and the negative terminal P- of the battery pack 10 is divided using a plurality of resistors, and the voltage divided by the plurality of resistors may be used as the second voltage.

The first insulation resistance monitoring circuit 110 and the second insulation resistance monitoring circuit 120 may be monitoring circuits for measuring the insulation resistance of the battery system 1.

The third insulation resistance monitoring circuit 130 may be connected between the positive connection terminal OT+ of the battery system 1 and the ground terminal of the external device 2, and may output a third voltage corresponding to the voltage difference between the positive connection terminal OT+ of the battery system 1 and the ground terminal of the external device 2 to the MCU 160. For example, the voltage difference between the positive connection terminal OT+ of the battery system 1 and the ground terminal of the external device 2 is divided using a plurality of resistors, and the voltage divided by the plurality of resistors may be used as the third voltage.

The fourth insulation resistance monitoring circuit 140 may be connected between the ground terminal of the external device 2 and the negative connection terminal OT- of the battery system 1, and may output a fourth voltage corresponding to the voltage difference between the ground terminal of the external device 2 and the negative connection terminal OT- of the battery system 1 to the MCU 160. For example, the voltage difference between the ground terminal of the external device 2 and the negative connection terminal OT- of the battery system 1 is divided using a plurality of resistors, and the voltage divided by the plurality of resistors may be used as the fourth voltage.

The third insulation resistance monitoring circuit 130 and the fourth insulation resistance monitoring circuit 140 may be monitoring circuits for measuring the insulation resistance of the inverter 210, i.e., the load.

The voltage monitoring circuit 150 may be connected between the positive terminal P+ and the negative terminal P- of the battery pack 10, and may output a pack voltage of the battery pack 10, which corresponds to the voltage difference between the positive terminal P+ and the negative terminal P- of the battery pack 10, to the MCU 160.

In some embodiments, the first insulation resistance monitoring circuit 110, the second insulation resistance monitoring circuit 120, the third insulation resistance monitoring circuit 130, the fourth insulation resistance monitoring circuit 140, and the voltage monitoring circuit 150 may each convert the corresponding voltage into a digital signal and provide the digital signal of the corresponding voltage to the MCU 160.

The MCU 160 may measure the insulation resistances RPI1, RNI1, RPI2, and RNI2 using the first voltage, the second voltage, the third voltage, the fourth voltage, and the pack voltage output from the first insulation resistance monitoring circuit 110, the second insulation resistance monitoring circuit 120, the third insulation resistance monitoring circuit 130, the fourth insulation resistance monitoring circuit 140, and the voltage monitoring circuit 150, respectively.

The MCU 160 may diagnose the insulation state of the loads of the battery system 1 and the external device 2 using the measured insulation resistances RPI1, RNI1, RPI2, and RNI2.

In some embodiments, the MCU 160 may perform the overall functions of the BMS. The MCU 160 may control and manage the overall operation of the battery system 1. For example, the MCU 160 may monitor the overall state of the battery pack 10 and the battery cells included therein using the pack voltage, cell voltages of the battery cells, and the current of the battery pack 10, and may control the charging and discharging of the battery pack 10 and perform cell balancing operations. The MCU 160 may control the on/off state of the first relay 20 and the second relay 30 to control the charging and discharging of the battery pack 10.

The MCU 160 may be implemented using at least one of an application specific integrated circuit (ASIC), digital signal processor (DSP), digital signal processing device (DSPD), programmable logic device (PLD), field programmable gate array (FPGA), a microprocessor, an application processor (AP), a central processing unit (CPU), a graphic processing unit (GPU), or other electrical units for performing functions.

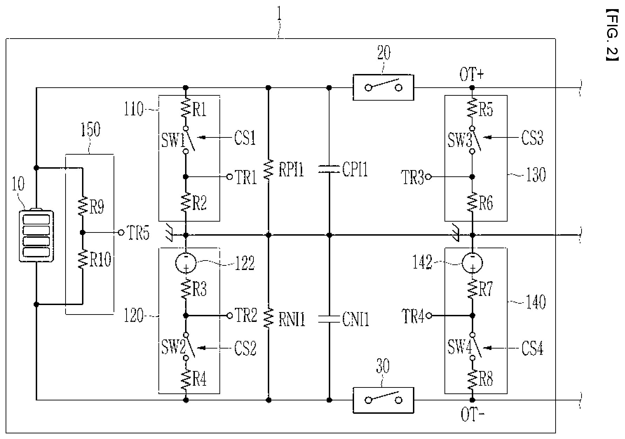

FIG. 2 is a diagram illustrating an example of the first to fourth insulation resistance monitoring circuits and the voltage monitoring circuit shown in FIG. 1.

Referring to FIG. 2, the first insulation resistance monitoring circuit 110 may include resistors R1 and R2 and a first switch SW1. One end of resistor R1 may be connected to the positive terminal P+ of the battery pack 10. The first switch SW1 may be connected between the other end of resistor R1 and one end of resistor R2. The other end of resistor R2 may be connected to the ground terminal of the external device 2. The first switch SW1 may be turned on or off according to a switch control signal CS1 from the MCU 160.

The first insulation resistance monitoring circuit 110 has a first insulation resistance monitoring terminal TR1 on a path formed by the resistors R1 and R2 and the first switch SW1. The first insulation resistance monitoring terminal TR1 may be connected to one end of resistor R2 and may output a first voltage corresponding to the voltage difference between the positive terminal P+ of the battery pack 10 and the ground terminal of the external device 2.

In some embodiments, the first insulation resistance monitoring terminal TR1 may be connected to the other end of resistor R1.

In some embodiments, the connection order of the resistors R1 and R2 and the first switch SW1 between the positive terminal P+ of the battery pack 10 and the ground terminal may be changed. In this case, a node (e.g., a junction of resistors R1 and R2) where the voltage is divided by the resistors R1 and R2 may be set as the first insulation resistance monitoring terminal TR1.

The second insulation resistance monitoring circuit 120 may include resistors R3 and R4 and a second switch SW2. One end of resistor R3 may be connected to the ground terminal of the external device 2, and the second switch SW2 may be connected between the other end of resistor R3 and one end of resistor R4. The other end of resistor R4 may be connected to the negative terminal P- of the battery pack 10. The second switch SW2 may be turned on or off according to a switch control signal CS2 from the MCU 160.

The second insulation resistance monitoring circuit 120 has a second insulation resistance monitoring terminal TR2 on a path formed by the resistors R3 and R4 and the second switch SW2. The second insulation resistance monitoring terminal TR2 may be connected to the other end of resistor R3 and may output a second voltage corresponding to the voltage difference between the ground terminal of the external device 2 and the negative terminal P- of the battery pack 10.

In some embodiments, the second insulation resistance monitoring terminal TR2 may be connected to one end of resistor R4.

In some embodiments, the second insulation resistance monitoring circuit 120 may further include a DC voltage source 122 on the path formed by the resistors R3 and R4 and the second switch SW2. Since the resistors R3 and R4 are connected between the ground terminal and the negative terminal P- of the battery pack 10, the DC voltage source 122 may be provided such that the voltage of the second insulation resistance monitoring terminal TR2 becomes a positive voltage. The negative terminal of the DC voltage source 122 may be connected to the ground terminal, and the positive terminal of the DC voltage source 122 may be connected to one end of resistor R3.

In some embodiments, the connection order of the DC voltage source 122, the resistors R3 and R4, and the second switch SW2 between the ground terminal and the negative terminal P- of the battery pack 10 may be changed. In this case, a node (e.g., a junction of resistors R3 and R4) where the voltage is divided by the resistors R3 and R4 may be set as the second insulation resistance monitoring terminal TR2.

The third insulation resistance monitoring circuit 130 may include resistors R5 and R6 and a third switch SW3. One end of resistor R5 may be connected to the positive connection terminal OT+ of the battery system 1. The third switch SW3 may be connected between the other end of resistor R5 and one end of resistor R6. The other end of resistor R6 may be connected to the ground terminal of the external device 2. The third switch SW3 may be turned on or off according to a switch control signal CS3 from the MCU 160.

The third insulation resistance monitoring circuit 130 has a third insulation resistance monitoring terminal TR3 on a path formed by the resistors R5 and R6 and the third switch SW3. The third insulation resistance monitoring terminal TR3 may be connected to one end of resistor R6 and may output a third voltage corresponding to the voltage difference between the positive connection terminal OT+ of the battery system 1 and the ground terminal of the external device 2 to the MCU 160.

In some embodiments, the third insulation resistance monitoring terminal TR3 may be connected to the other end of resistor R5.

In some embodiments, the connection order of the resistors R5 and R6 and the third switch SW3 between the positive connection terminal OT+ of the battery system 1 and the ground terminal may be changed. In this case, a node (e.g., a junction of resistors R5 and R6) where the voltage is divided by the resistors R5 and R6 may be set as the third insulation resistance monitoring terminal TR3.

The fourth insulation resistance monitoring circuit 140 may include resistors R7 and R8 and a fourth switch SW4. One end of resistor R7 may be connected to the ground terminal of the external device 2, and the fourth switch SW4 may be connected between the other end of resistor R7 and one end of resistor R8. The other end of resistor R8 may be connected to the negative connection terminal OT- of the battery system 1. The fourth switch SW4 may be turned on or off according to a switch control signal CS4 from the MCU 160.

The fourth insulation resistance monitoring circuit 140 has a fourth insulation resistance monitoring terminal TR4 on a path formed by the resistors R7 and R8 and the fourth switch SW4. The fourth insulation resistance monitoring terminal TR4 may be connected to the other end of resistor R7 and may output a fourth voltage corresponding to the voltage difference between the ground terminal of the external device 2 and the negative connection terminal OT- of the battery system 1 to the MCU 160.

In some embodiments, the fourth insulation resistance monitoring terminal TR4 may be connected to one end of resistor R8.

In some embodiments, the fourth insulation resistance monitoring circuit 140 may further include a DC voltage source 142 on the path formed by the resistors R7 and R8 and the fourth switch SW4. Since the resistors R7 and R8 are connected between the ground terminal and the negative connection terminal OT- of the battery system 1, the DC voltage source 142 may be provided such that the voltage of the fourth insulation resistance monitoring terminal TR4 becomes a positive voltage. The negative terminal of the DC voltage source 142 may be connected to the ground terminal, and the positive terminal of the DC voltage source 142 may be connected to one end of resistor R7.

In some embodiments, the connection order of the DC voltage source 142, the resistors R7 and R8, and the fourth switch SW4 between the ground terminal and the negative output terminal OT- of the battery system 1 may be changed. In this case, a node (e.g., a junction of resistors R7 and R8) where the voltage is divided by the resistors R7 and R8 may be set as the fourth insulation resistance monitoring terminal TR4.

The voltage monitoring circuit 150 may include resistors R9 and R10. One end of resistor R9 may be connected to the positive terminal P+ of the battery pack 10, the other end of resistor R9 may be connected to one end of resistor R10, and the other end of resistor R10 may be connected to the negative terminal P- of the battery pack 10.

The voltage monitoring circuit 150 has a voltage monitoring terminal TR5 on a path formed by the resistors R9 and R10. The voltage monitoring terminal TR5 may be connected to the other end of resistor R9 or one end of resistor R10, and may output a pack voltage corresponding to the voltage difference between the positive terminal P+ and the negative terminal P- of the battery pack 10.

In some embodiments, the voltage monitoring circuit 150 may measure the voltages of the plurality of battery cells of the battery pack 10, respectively, and provide the voltages of the plurality of battery cells to the MCU 160, so that the MCU 160 can calculate the pack voltage.

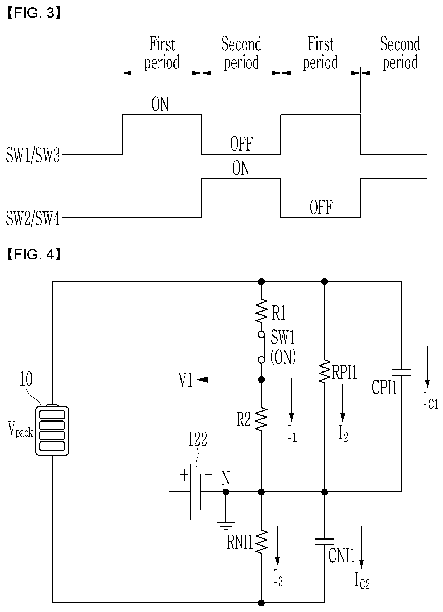

FIG. 3 is a diagram illustrating an example of switch timing for insulation resistance measurement according to an embodiment.

Referring to FIG. 3, the MCU 160 may simultaneously turn on the first switch SW1 and the third switch SW3 and simultaneously turn off the second switch SW2 and the fourth switch SW4 during a first period. The MCU 160 may simultaneously turn on the second switch SW2 and the fourth switch SW4 and simultaneously turn off the first switch SW1 and the third switch SW3 during a second period. The MCU 160 may repeat the first period and the second period during an insulation resistance measurement period.

Alternatively, the MCU 160 may set the first switch SW1, the second switch SW2, the third switch SW3, and the fourth switch SW4 to an on state one by one.

Meanwhile, during insulation resistance measurement, the first relay 20 and the second relay 30 may be in an on state or an off state, and may transition from the on state to the off state or from the off state to the on state.

For example, when the external device 2 is a vehicle, the first relay 20 and the second relay 30 may transition from the off state to the on state when the vehicle is started. The first relay 20 and the second relay 30 may be maintained in the on state while the vehicle is driving, and the first relay 20 and the second relay 30 may transition from the on state to the off state when the vehicle is turned off.

In addition, the MCU 160 may set the first relay 20 and the second relay 30 to the off state and set the third switch SW3 and the fourth switch SW4 to the on state to discharge the Y-capacitors CPI2 and CNI2 for insulation resistance measurement.

FIG. 4 is a diagram illustrating the voltage of a first insulation resistance monitoring terminal when a first switch is turned on while a first relay and a second relay shown in FIG. 2 are in an off state.

Referring to FIG. 4, by turning on the first switch SW1, a current path may be formed through the resistors R1 and R2 between the positive terminal P+ of the battery pack 10 and the ground terminal of the external device 2. Additionally, since the second switch SW2 is in an off state, a current path through the resistors R3 and R4 is not formed. In this case, since an insulation resistance RPI1 and a Y-capacitor CPI1 are formed between the positive terminal P+ of the battery pack 10 and the ground terminal of the external device 2, a circuit in which a set of the resistors R1 and R2, the insulation resistance RPI1, and the Y-capacitor CPI1 are connected in parallel is formed between the positive terminal P+ of the battery pack 10 and the ground terminal of the external device 2. Furthermore, a circuit in which an insulation resistance RNI1 and a Y-capacitor CNI1 are connected in parallel may be formed between the ground terminal and the negative terminal P- of the battery pack 10.

In this state, the MCU 160 may receive a voltage V1 of the first insulation resistance monitoring terminal TR1.

In the circuit shown in FIG. 4, let the current flowing through the resistors R1 and R2 of the first insulation resistance monitoring circuit 110 be I₁, the current flowing through the insulation resistance RPI1 be I₂, the current flowing through the Y-capacitor CPI1 be I_{C1}, the current flowing through the Y-capacitor CNI1 be I_{C2}, and the current flowing through the insulation resistance RNI1 be I₃. Applying Kirchhoff's current law based on the node N connected to the ground terminal, the relationship of Equation 1 may be established. [Equation 1] ${I}_{1} + {I}_{2} + {I}_{C 1} = {I}_{3} + {I}_{C 2}$

Below, for convenience, the description will be made while ignoring the currents flowing through the Y-capacitor CPI1 and the Y-capacitor CNI1. Accordingly, Equation 1 may be simply expressed as Equation 2. [Equation 2] ${I}_{1} + {I}_{2} = {I}_{3}$

When the voltage of the first insulation resistance monitoring terminal TR1 is V1, V1 may establish a relationship as shown in Equation 3. [Equation 3] ${I}_{1} = \frac{V 1}{{R}_{2}}$

When the set of resistors R1 and R2 and the insulation resistance RPI1 are connected in parallel between the positive terminal P+ of the battery pack 10 and the ground terminal of the external device 2, the voltage applied across each of them is the same, and thus, the relationship of Equation 4 may be established. [Equation 4] ${I}_{1} {R}_{1} + V 1 = {I}_{2} {R}_{P 1}$

From Equation 4, I₂ may be expressed as Equation 5. [Equation 5] ${I}_{2} = \frac{{I}_{1} {R}_{1} + V 1}{{R}_{P 1}} = \frac{\frac{V 1}{{R}_{2}} {R}_{1} + V 1}{{R}_{P 1}}$

From Equations 2, 3, and 5, I₃ may establish the relationship of Equation 6. [Equation 6] ${I}_{3} = \frac{V 1}{{R}_{2}} + \frac{\frac{V 1}{{R}_{2}} {R}_{1} + V 1}{{R}_{P 1}}$

In addition, when the voltage of the battery pack 10 is V_{pack}, V_{pack} may establish the relationship of Equation 7. [Equation 7] ${V}_{pack} = {I}_{2} {R}_{P 1} + {I}_{3} {R}_{N 1}$

In the relationship of Equation 7, by applying Equation 5 and Equation 6, the relationship between the voltage V_{pack} of the battery pack 10 and the voltage V1 of the first insulation resistance monitoring terminal TR1 may be determined as shown in Equation 8. [Equation 8] ${V}_{pack} = \frac{V 1}{{R}_{2}} {R}_{1} + V 1 + \left(\frac{V 1}{{R}_{2}}+\frac{\frac{V 1}{{R}_{2}} {R}_{1} + V 1}{{R}_{P 1}}\right) {R}_{N 1}$

In Equations 3 to 8, R₁ is the resistance value of resistor R1, R₂ is the resistance value of resistor R2, R_{P1} is the resistance value of insulation resistance RPI1, and R_{N1} is the resistance value of insulation resistance RNI1.

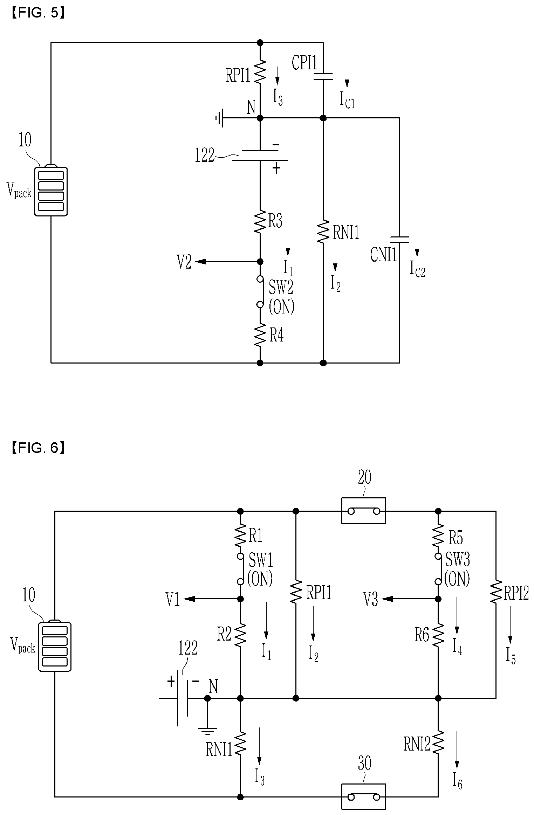

FIG. 5 is a diagram illustrating the voltage of a second insulation resistance monitoring terminal when a second switch is turned on while the first relay and the second relay shown in FIG. 2 are in an off state.

Referring to FIG. 5, by turning on the second switch SW2, a current path may be formed through the resistors R3 and R4 between the ground terminal of the external device 2 and the negative terminal P-of the battery pack 10. In addition, since the first switch SW1 is in an off state, a current path through the resistors R1 and R2 is not formed. In this case, since an insulation resistance RNI1 and a Y-capacitor CNI1 are formed between the ground terminal of the external device 2 and the negative terminal P- of the battery pack 10, a circuit in which a set of the resistors R3 and R4, the insulation resistance RNI1, and the Y-capacitor CNI1 are connected in parallel is formed between the ground terminal of the external device 2 and the negative terminal P- of the battery pack 10. Furthermore, a circuit in which an insulation resistance RPI1 and a Y-capacitor CPI1 are connected in parallel may be formed between the positive terminal P+ of the battery pack 10 and the ground terminal.

In this state, the MCU 160 may receive a voltage V2 of the second insulation resistance monitoring terminal TR2.

In the circuit shown in FIG. 5, let the current flowing through the resistors R3 and R4 of the second insulation resistance monitoring circuit 120 be I₁, the current flowing through the insulation resistance RNI1 be I₂, the current flowing through the Y-capacitor CPI1 be I_{C1}, the current flowing through the Y-capacitor CNI1 be I_{C2}, and the current flowing through the insulation resistance RPI1 be I₃. Applying Kirchhoff's current law based on the node N connected to the ground terminal, the relationship of Equation 9 may be established. [Equation 9] ${I}_{1} + {I}_{2} + {I}_{C 2} = {I}_{3} + {I}_{C 1}$

Since the Y-capacitors CPI1, CNI1, CPI2, and CNI2 are discharged before the start of the insulation resistance measurement, the circuit part involving the Y-capacitors CPI1 and CNI1 will be omitted from the description. Accordingly, Equation 9 may be expressed as Equation 10. [Equation 10] ${I}_{1} + {I}_{2} = {I}_{3}$

When the voltage of the second insulation resistance monitoring terminal TR2 is V2 and the voltage supplied by the DC voltage source 122 is VDC, V2 may establish a relationship as shown in Equation 11. [Equation 11] $V 2 = VDC - {I}_{1} {R}_{3}$

From Equation 11, I₁ may establish the relationship of Equation 12. [Equation 12] ${I}_{1} = \frac{VDC - V 2}{{R}_{3}}$

When the DC voltage source 122 and the set of resistors R3 and R4 and the insulation resistance RNI1 are connected in parallel between the ground terminal of the external device 2 and the negative terminal P- of the battery pack 10, the voltage applied across each of them is the same, and thus, the relationship of Equation 13 may be established. [Equation 13] ${I}_{1} {R}_{4} - V 2 = {I}_{2} {R}_{N 1}$

From Equation 13, I₂ may be expressed as Equation 14. [Equation 14] ${I}_{2} = \frac{{I}_{1} {R}_{4} - V 2}{{R}_{N 1}} = \frac{\frac{VDC - V 2}{{R}_{3}} {R}_{4} + V 2}{{R}_{N 1}}$

From Equations 10, 12, and 14, I₃ may establish the relationship of Equation 15. [Equation 15] ${I}_{3} = \frac{VDC - V 2}{{R}_{3}} + \frac{\frac{VDC - V 2}{{R}_{3}} {R}_{4} + V 2}{{R}_{N 1}}$

In addition, when the voltage of the battery pack 10 is V_{pack}, V_{pack} may establish the relationship of Equation 16. [Equation 16] ${V}_{pack} = {I}_{2} {R}_{P 1} + {I}_{3} {R}_{N 1}$

In the relationship of Equation 16, by applying Equation 14 and Equation 15, the relationship between the voltage V_{pack} of the battery pack 10 and the voltage V2 of the second insulation resistance monitoring terminal TR2 may be determined as shown in Equation 17. [Equation 17] ${V}_{pack} = \frac{VDC - V 2}{{R}_{3}} {R}_{4} - V 2 + \left(\frac{VDC - V 2}{{R}_{3}}+\frac{\frac{VDC - V 2}{{R}_{3}} {R}_{4} - V 2}{{R}_{N 1}}\right) {R}_{P 1}$

In Equations 11 to 17, R₃ is the resistance value of resistor R3, R₄ is the resistance value of resistor R4, R_{P1} is the resistance value of insulation resistance RPI1, and R_{N1} is the resistance value of insulation resistance RNI1.

The MCU 160 may calculate the resistance values of the insulation resistances RPI1 and RNI1 based on the voltage V1 of the first insulation resistance monitoring terminal TR1, the voltage V2 of the second insulation resistance monitoring terminal TR2, and the voltage V_{pack} of the battery pack 10. Based on Equations 8 and 17, the MCU 160 may calculate the resistance values of the insulation resistances RPI1 and RNI1 as shown in Equation 18 and Equation 19, respectively. [Equation 18] ${R}_{P 1} = \frac{\left({V}_{pack}-A\right) \left({V}_{pack}-C\right) - AC}{D \left({V}_{pack}-A\right) + BC}$ [Equation 19] ${R}_{N 1} = \frac{\left({V}_{pack}-A\right) \left({V}_{pack}-C\right) - AC}{B \left({V}_{pack}-C\right) + AD}$

In Equation 18 and Equation 19, A, B, C, and D may be defined as shown in Equation 20, Equation 21, Equation 22, and Equation 23, respectively. [Equation 20] $A = \frac{V 1}{{R}_{2}} {R}_{1} + V 1$ [Equation 21] $B = \frac{V 1}{{R}_{2}}$ [Equation 22] $C = \frac{VDC - V 2}{{R}_{4}} {R}_{3} - V 2$ [Equation 23] $D = \frac{VDC - V 2}{{R}_{4}}$

In addition, when the third switch SW3 is turned on while the first relay 20 and the second relay 30 are in an off state, the MCU 160 may receive a voltage V3 of the third insulation resistance monitoring terminal TR3. Assuming that the voltage V_{pack} of the battery pack 10 is charged in the capacitor C1, a relationship between the voltage charged in the capacitor C1 and the voltage V3 of the third insulation resistance monitoring terminal TR3 may be derived similarly to the description based on Equations 1 to 8. However, since the capacitor C1 gradually discharges, the voltage V3 of the third insulation resistance monitoring terminal TR3 may be used for insulation resistance measurement for a predetermined period of time after the first relay 20 and the second relay 30 are turned off.

Furthermore, when the fourth switch SW4 is turned on while the first relay 20 and the second relay 30 are in an off state, the voltage supplied by the DC voltage source 142 may be divided by the resistors R7 and R8, and the MCU 160 may receive the voltage divided by the resistors R7 and R8 as the voltage V4 of the fourth insulation resistance monitoring terminal TR4.

The MCU 160 may calculate the resistance values of the insulation resistances RPI2 and RNI2 based on the voltage V3 of the third insulation resistance monitoring terminal TR3, the voltage V4 of the fourth insulation resistance monitoring terminal TR4, and the voltage of the capacitor C1.

FIG. 6 is a diagram illustrating the voltages of the first and third insulation resistance monitoring terminals when the first switch and a third switch are turned on while the first relay and the second relay shown in FIG. 2 are in an on state.

Referring to FIG. 6, by turning on the first switch SW1 and the third switch SW3 while the first relay 20 and the second relay 30 are in an on state, current paths may be formed through resistors R1 and R2 and resistors R5 and R6 between the positive terminal P) of the battery pack 10 and the ground terminal of the external device 2. Additionally, since the second switch SW2 and the fourth switch SW4 are in an off state, current paths through the resistors R3 and R4 and the resistors R7 and R8 are not formed. In this case, since insulation resistances RPI1 and RPI2 are formed between the positive terminal P+ of the battery pack 10 and the ground terminal of the external device, a circuit in which a set of the resistors R1 and R2, a set of the resistors R5 and R6, the insulation resistance RPI1, and the insulation resistance RPI2 are connected in parallel is formed between the positive terminal P+ of the battery pack 10 and the ground terminal of the external device 2. Furthermore, a circuit in which insulation resistances RNI1 and RNI2 are connected in parallel may be formed between the ground terminal and the negative terminal P- of the battery pack 10. In FIG. 6, the Y-capacitors CPI1, CPI2, CNI1, and CNI2 are omitted for convenience.

In this state, the MCU 160 may receive a voltage V1 of the first insulation resistance monitoring terminal TR1 and a voltage V3 of the third insulation resistance monitoring terminal TR3.

In the circuit shown in FIG. 6, let the current flowing through the resistors R1 and R2 of the first insulation resistance monitoring circuit 110 be I₁, the current through the insulation resistance RPI1 be I₂, the current through the insulation resistance RNI1 be I₃, the current through the resistors R5 and R6 be I₄, the current through the insulation resistance RPI2 be I₅, and the current through the insulation resistance RNI2 be I₆. Applying Kirchhoff's current law based on the node N connected to the ground terminal, the relationship of Equation 24 may be established. [Equation 24] ${I}_{1} + {I}_{2} + {I}_{4} + {I}_{5} = {I}_{3} + {I}_{6}$

When the voltage of the first insulation resistance monitoring terminal TR1 is V1, V1 may establish a relationship as shown in Equation 25. [Equation 25] ${I}_{1} = \frac{V 1}{{R}_{2}}$

In addition, when the voltage of the third insulation resistance monitoring terminal TR3 is V3, V3 may establish a relationship as shown in Equation 26. [Equation 26] ${I}_{4} = \frac{V 3}{{R}_{6}}$

When the set of resistors R1 and R2, the set of resistors R5 and R6, and the insulation resistances RPI1 and RPI2 are connected in parallel between the positive terminal P+ of the battery pack 10 and the ground terminal of the external device 2, the voltage applied across each of them is the same, and thus, the relationship of Equation 27 may be established. [Equation 27] ${I}_{1} {R}_{1} + V 1 = {I}_{2} {R}_{P 1} = {I}_{4} {R}_{5} + V 3 = {I}_{5} {R}_{P 2}$

From Equation 27, I₂ and I₅ may be expressed as shown in Equation 28 and Equation 29. [Equation 28] ${I}_{2} = \frac{{I}_{1} {R}_{1} + V 1}{{R}_{P 1}} = \frac{\frac{V 1}{{R}_{2}} {R}_{1} + V 1}{{R}_{P 1}}$ [Equation 29] ${I}_{5} = \frac{{I}_{4} {R}_{5} + V 3}{{R}_{P 2}} = \frac{\frac{V 3}{{R}_{6}} {R}_{5} + V 3}{{R}_{P 2}}$

In Equations 25 to 29, R₁ is the resistance value of resistor R1, R₂ is the resistance value of resistor R2, R₅ is the resistance value of resistor R5, R₆ is the resistance value of resistor R6. Furthermore, R_{P1} is the resistance value of insulation resistance RPI1, and R_{P2} is the resistance value of insulation resistance RPI2.

When an insulation breakdown occurs, current flows through a resistance with a low resistance value. Therefore, by calculating the composite resistance of the insulation resistances RNI1 and RNI2 and simplifying I₃ and I₆ into a current I₇ flowing through the composite resistance, the current I₇ may be derived.

When insulation resistors RNI1 and RNI2 are connected in parallel between the ground terminal of the external device 2 and the negative terminal P- of the battery pack 10, if insulation breakdown occurs, the resistance value of the corresponding insulation resistor decreases, and current flows through the resistor with the low resistance value. Therefore, if the composite resistance of the insulation resistors RNI1 and RNI2 is calculated and I₃ and I₆ are simplified into the current I₇ flowing through the composite resistance, the current I₇ may be derived. Using the current I₇ flowing through the composite resistance of the insulation resistors RNI1 and RNI2 and the method described above, the relationship between the voltage V_{pack} of the battery pack 10 and the voltage V1 of the first insulation resistance monitoring terminal TR1 and the relationship between the voltage V_{pack} of the battery pack 10 and the voltage V3 of the third insulation resistance monitoring terminal TR3 may be determined.

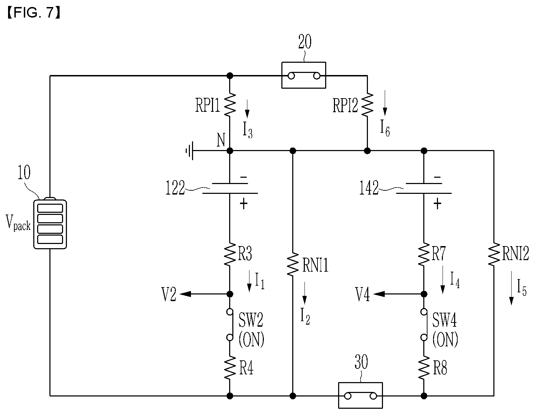

FIG. 7 is a diagram illustrating the voltages of the second and fourth insulation resistance monitoring terminals when the second switch and a fourth switch are turned on while the first relay and the second relay shown in FIG. 2 are in an on state.

Referring to FIG. 7, by turning on the second switch SW2 and the fourth switch SW4 while the first relay 20 and the second relay 30 are in an on state, current paths may be formed through resistors R3 and R4 and resistors R7 and R8 between the ground terminal of the external device 2 and the negative terminal P- of the battery pack 10. In addition, since the first switch SW1 and the third switch SW3 are in an off state, current paths through the resistors R1 and R2 and the resistors R5 and R6 are not formed. In this case, since insulation resistances RNI1 and RNI2 are formed between the ground terminal of the external device 2 and the negative terminal P- of the battery pack 10, a circuit in which a set of the resistors R3 and R4, a set of the resistors R7 and R8, and the insulation resistances RNI1 and RNI2 are connected in parallel is formed between the ground terminal and the negative terminal P- of the battery pack 10. Furthermore, a circuit in which insulation resistances RPI1 and RPI2 are connected in parallel may be formed between the positive terminal P+ of the battery pack 10 and the ground terminal. In FIG. 7, the Y-capacitors CPI1, CPI2, CNI1, and CNI2 are omitted for convenience.

In this state, the MCU 160 may receive the voltage V of the second insulation resistance monitoring terminal TR2 and the voltage V4 of the fourth insulation resistance monitoring terminal TR4.

In the circuit shown in FIG. 7, let the current through the resistors R3 and R4 be I₁, the current through insulation resistance RNI1 be I₂, the current through insulation resistance RPI1 be I₃, the current through the resistors R7 and R8 be I₄, the current through insulation resistance RNI2 be I₅, and the current through insulation resistance RPI2 be I₆. Applying Kirchhoff's current law based on the node N, Equation 30 may be established. [Equation 30] ${I}_{1} + {I}_{2} + {I}_{4} + {I}_{5} = {I}_{3} + {I}_{6}$

When the voltage of the second insulation resistance monitoring terminal TR2 is V2 and the voltage supplied by the DC voltage source 122 is VDC, V2 may establish a relationship as shown in Equation 31. [Equation 31] $V 2 = VDC - {I}_{1} {R}_{3}$

From Equation 31, I₁ may establish the relationship of Equation 32. [Equation 32] ${I}_{1} = \frac{VDC - V 2}{{R}_{3}}$

In addition, when the voltage of the fourth insulation resistance monitoring terminal TR4 is V4, V4 may establish a relationship as shown in Equation 33. [Equation 33] $V 4 = VDC - {I}_{4} {R}_{7}$

From Equation 33, I₄ may establish the relationship of Equation 34. [Equation 34] ${I}_{4} = \frac{VDC - V 4}{{R}_{7}}$

Next, when the set of the DC voltage source 122 and resistors R3 and R4, the set of the DC voltage source 142 and resistors R7 and R8, and the insulation resistances RNI1 and RNI2 are connected in parallel between the ground terminal of the external device 2 and the negative terminal P- of the battery pack 10, the voltage applied across each of them is the same, and thus, the relationship of Equation 35 may be established. [Equation 35] ${I}_{1} {R}_{4} - V 2 = {I}_{2} {R}_{N 1} = {I}_{4} {R}_{8} - V 4 = {I}_{5} {R}_{N 2}$

From Equation 35, I₂ and I₅ may be expressed as shown in Equation 36 and Equation 37. [Equation 36] ${I}_{2} = \frac{{I}_{1} {R}_{4} - V 2}{{R}_{N 1}} = \frac{\frac{VDC - V 2}{{R}_{3}} {R}_{4} + V 2}{{R}_{N 1}}$ [Equation 37] ${I}_{5} = \frac{{I}_{4} {R}_{8} - V 4}{{R}_{N 2}} = \frac{\frac{VDC - V 4}{{R}_{7}} {R}_{4} + V 4}{{R}_{N 2}}$

In Equations 31 to 37, R₃ is the resistance value of resistor R3, R₄ is the resistance value of resistor R4, R₇ is the resistance value of resistor R7, R₈ is the resistance value of resistor R8. Furthermore, R_{N1} is the resistance value of insulation resistance RNI1, and R_{N2} is the resistance value of insulation resistance RNI2.

When insulation resistances RPI1 and RPI2 are connected in parallel and an insulation breakdown occurs, the resistance value of the corresponding insulation resistance decreases, and current flows through the path with lower resistance. Therefore, by calculating the composite resistance of the insulation resistances RPI1 and RPI2 and simplifying I₃ and I₆ into current I₇ flowing through the composite resistance of the insulation resistances RPI1 and RPI2, the current I₇ may be derived. Using the current I₇ and the previously described methods, the relationship between the pack voltage V_{pack} and the voltage V2 of the second insulation resistance monitoring terminal TR2, and the relationship between the pack voltage V_{pack} and the voltage V4 of the second insulation resistance monitoring terminal TR4, may be determined.

The MCU 160 may calculate the resistance values of the insulation resistances RPI2 and RNI2 based on the voltage V3 of the second insulation resistance monitoring terminal TR3, the voltage V4 of the second insulation resistance monitoring terminal TR4, and the voltage of the capacitor C1 while the first relay 20 and the second relay 30 are on.

In addition, the MCU 160 may calculate the resistance values of the insulation resistances RPI1 and RNI1 based on the voltage V1 of the second insulation resistance monitoring terminal TR1, the voltage V2 of the second insulation resistance monitoring terminal TR2, and the pack voltage V_{pack} while the first relay 20 and the second relay 30 are on.

Next, a method for diagnosing the insulation state of the battery system 1 and the external device 2 according to the on/off state of the first relay 20 and the second relay 30 in MCU (160) will be described.

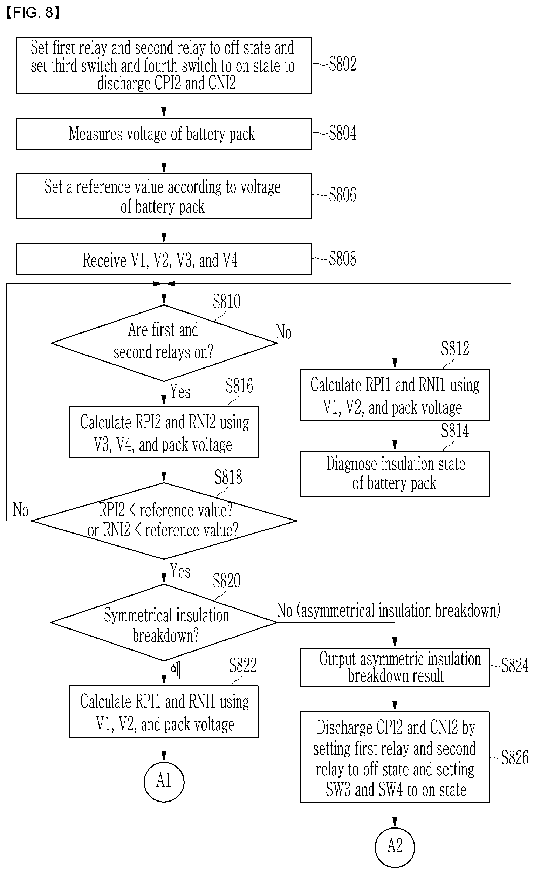

FIGS. 8 to 10 are flowcharts illustrating an insulation state diagnosis method when the first relay and the second relay transition from an off state to an on state according to an embodiment.

Referring to FIG. 8, when power is applied to the external device 2, the MCU 160 may set the first relay 20 and the second relay 30 to an off state and set the third switch SW3 and the fourth switch SW4 to an on state to discharge the Y-capacitors CPI2 and CNI2 connected to the inverter 210 (S802).

The MCU 160 measures the voltage of the battery pack 10 (S804) and sets a reference value (threshold) for insulation state diagnosis according to the voltage of the battery pack 10 (S806). That is, the reference value for insulation state diagnosis may be set differently depending on the voltage of the battery pack 10.

Next, for insulation resistance measurement, the MCU 160 may receive the voltage V1 of the first insulation resistance monitoring terminal TR1, the voltage V2 of the second insulation resistance monitoring terminal TR2, the voltage V3 of the third insulation resistance monitoring terminal TR3, and the voltage V4 of the fourth insulation resistance monitoring terminal TR4 at a set period (S808).

In some embodiments, as shown in FIG. 3, the MCU 160 may turn on the first and third switches SW1 and SW3 to simultaneously receive the voltage V1 of the first insulation resistance monitoring terminal TR1 and the voltage V3 of the third insulation resistance monitoring terminal TR3, and turn on the second and fourth switches SW2 and SW4 to simultaneously receive the voltage V2 of the second insulation resistance monitoring terminal TR2 and the voltage V4 of the fourth insulation resistance monitoring terminal TR4.

Alternatively, the MCU 160 may turn on the first to fourth switches SW1 to SW4 one by one in sequence to receive the voltage V1 of the first insulation resistance monitoring terminal TR1, the voltage V2 of the second insulation resistance monitoring terminal TR2, the voltage V3 of the third insulation resistance monitoring terminal TR3, and the voltage V4 of the fourth insulation resistance monitoring terminal TR4.

In some embodiments, if the first relay 20 and the second relay 30 are in an off state, the MCU 160 may receive the voltage V1 of the first insulation resistance monitoring terminal TR1 and the voltage V2 of the second insulation resistance monitoring terminal TR2. When the relays transition from an on state to an off state, the MCU 160 may receive the voltage V3 of the third insulation resistance monitoring terminal TR3 for a predetermined period.

In some embodiments, if the first relay 20 and the second relay 30 are in an on state, the MCU 160 may receive the voltage V1 of the first insulation resistance monitoring terminal TR1, the voltage V2 of the second insulation resistance monitoring terminal TR2, the voltage V3 of the third insulation resistance monitoring terminal TR3, and the voltage V4 of the fourth insulation resistance monitoring terminal TR4.

The MCU 160 may diagnose the insulation state of the battery pack 10 and the inverter 210 using the received voltages V1, V2, V3, and V4.

When the first relay 20 and the second relay 30 are off, the MCU 160 may calculate the resistance values of the insulation resistances RPI1 and RNI1 using the voltage V1 of the first insulation resistance monitoring terminal TR1, the voltage V2 of the second insulation resistance monitoring terminal TR2, and the pack voltage (S812) and diagnose the insulation state between the positive terminal P+ of the battery pack 10 and the ground terminal and the insulation state between the ground terminal and the negative terminal P- of the battery pack 10 (S814).

Meanwhile, when the relays 10 and 20 transition from the off state to the on state (S810), the MCU 160 may calculate the resistance values of the insulation resistances RPI2 and RNI2 using the voltage V3 of the third insulation resistance monitoring terminal TR3, the voltage V4 of the fourth insulation resistance monitoring terminal TR4, and the pack voltage (S816) and diagnose the insulation state between the first terminal of the inverter 210 connected to the positive connection terminal OT+ of the battery system 1 and the ground terminal, and the insulation status between the second terminal of the inverter 210 connected to the negative connection terminal OT- of the battery system 1 and the ground terminal.

If the resistance value of insulation resistance RPI2 or insulation resistance RNI2 is less than the reference value (S818), the MCU 160 may diagnose the insulation state of the inverter 210 as an insulation breakdown.

If both the resistance value of insulation resistance RPI2 or insulation resistance RNI2 are less than the reference value, the MCU 160 may diagnose that both the insulation state between the first terminal of the inverter 210 and the ground terminal and the insulation status between the second terminal of the inverter 210 and the ground terminal are insulation breakdowns. In this case, the insulation state of the inverter 210 may be a symmetrical insulation breakdown.

If the resistance value of the insulation resistor RPI2 is less than the reference value and the resistance value of the insulation resistor RNI2 is greater than the reference value, the MCU 160 may detect an insulation breakdown between the first terminal of the inverter 210 and the ground terminal. In this case, the insulation state of the inverter 210 may be an asymmetrical insulation breakdown.

If the resistance value of the insulation resistor RPI2 is greater than the reference value and the resistance value of the insulation resistor RNI2 is less than the reference value, the MCU 160 may detect an insulation breakdown between the second terminal of the inverter 210 and the ground terminal. In this case, the insulation state of the inverter 210 may be an asymmetrical insulation breakdown.

If the inverter 210 is in a symmetric insulation breakdown, the MCU 160 calculate the resistance values of the insulation resistances RPI1 and RNI1 using the voltage V1 of the first insulation resistance monitoring terminal TR1, the voltage V2 of the second insulation resistance monitoring terminal TR2, and the pack voltage (S822), and diagnose the insulation state between the positive terminal P+ of the battery pack 10 and the ground terminal and the insulation state between the ground terminal and the negative terminal P- of the battery pack 10.

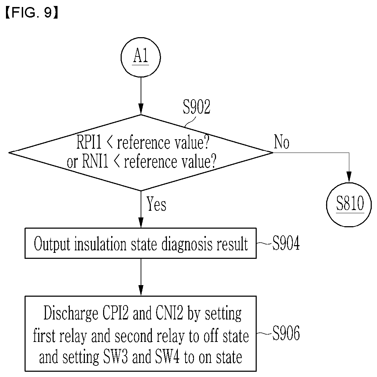

Referring to FIG. 9, if the resistance value of the insulation resistance RPI1 is less than the reference value or if the resistance value of the insulation resistance RNI1 is less than the reference value (S902), the MCU 160 may diagnose that the insulation status of the battery pack 10 is an insulation breakdown.

If the insulation state of the inverter 210 is a symmetrical insulation breakdown, and the insulation state between the positive terminal P+ of the battery pack 10 and the ground terminal or the insulation state between the ground terminal and the negative terminal P- of the battery pack 10 is an insulation breakdown, the MCU 160 may output an insulation breakdown as the final insulation state diagnosis result (S904). If the insulation state of the inverter 210 is a symmetrical insulation breakdown, and the insulation state between the positive terminal P+ of the battery pack 10 and the ground terminal or the insulation state between the ground terminal and the negative terminal P- of the battery pack 10 is an insulation breakdown, the MCU 160 may output an insulation breakdown as the final insulation state diagnosis result.

Next, the MCU 160 may discharge the Y-capacitor CPI2 and CNI2 connected to the inverter 210 by setting the first relay 20 and the second relay 30 to the off state and setting the third switch SW3 and the fourth switch SW4 to the on state (S906).

In this way, if the MCU 160 determines that the insulation status of the inverter 210 is symmetrical insulation breakdown and the insulation status of the battery pack 10 is insulation breakdown, it may discharge the Y-capacitors CPI2 and CNI2 connected to the inverter 210 for safety reasons (S906).

Before discharging the Y-capacitors CPI2 and CNI2, the MCU 160 may output an insulation status diagnosis result, thereby notifying that the first relay 20 and the second relay 30 will be set to the off state.

Returning to FIG. 8, in step S820, if the insulation state of the inverter 210 is an asymmetric insulation breakdown, the MCU 160 outputs an asymmetric insulation breakdown result (S824).

This output may serve to notify that the relays will be turned off.

In some embodiments, when the external device 2 is a hybrid vehicle using two or more power sources, if the external device 2 receives an asymmetric insulation breakdown result, it may switch the power source from the battery system to another source (e.g., an engine).

In some embodiments, when the external device 2 is a vehicle that uses only the battery system 1 as a power source, if the external device 2 receives an asymmetric insulation breakdown result, it may stop driving.

Next, after the MCU 160 outputs the asymmetric insulation breakdown result, the MCU 160 may discharge the Y-capacitor CPI2 and CNI2 connected to the inverter 210 by setting the first relay 20 and the second relay 30 to the off state and setting the third switch SW3 and the fourth switch SW4 to the on state (S826), and the insulation status of the inverter 210 may be re-diagnosed.

That is, if an asymmetric insulation breakdown is diagnosed, the Y-capacitors CPI2 and CNI2 are discharged and the insulation status of the inverter 210 is re-diagnosed, thereby reconfirming whether the asymmetric insulation breakdown was caused by a misdiagnosis.

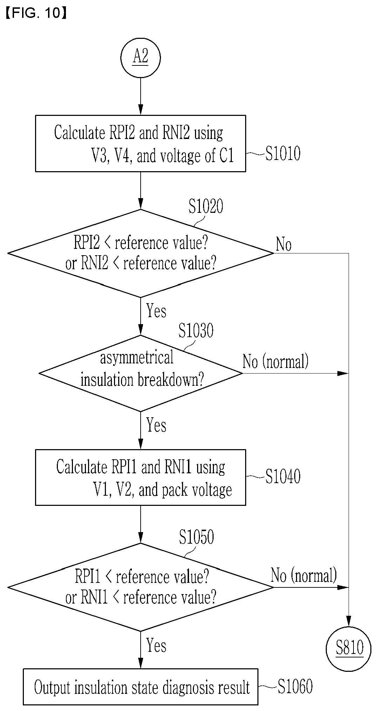

Referring to FIG. 10, after discharging the Y-capacitors CPI2 and CNI2, the MCU 160 calculates the resistance values of RPI2 and RNI2 using the voltage V3 of the third insulation resistance monitoring terminal TR3, the voltage V4 of the fourth insulation resistance monitoring terminal TR4, and the pack voltage V_{pack} (S1010).

If the resistance value of the insulation resistor RPI2 is less than the reference value or the resistance value of the insulation resistor RNI2 is less than the reference value (S1020), the MCU 160 may determine whether the insulation state of the inverter 210 is still an asymmetric insulation breakdown.

If the insulation status of the inverter 210 is still determined to be an asymmetrical insulation breakdown (S1030), the MCU 160 may calculate the resistance values of the insulation resistance RPI1 and RNI1 using the voltage V1 of the first insulation resistance monitoring terminal TR1, the voltage V2 of the second insulation resistance monitoring terminal TR1, and the pack voltage V_{pack} (S1040), and may diagnose the insulation status between the positive terminal P+ and the ground terminal of the battery pack 10 and the insulation status between the ground terminal and the negative terminal P- of the battery pack 10 by comparing the resistance values of the insulation resistance RPI1 and RNI1 with the reference value.

If the resistance value of the insulation resistance RPI1 is less than the reference value or the resistance value of the insulation resistance RNI1 is less than the reference value (S1050), the MCU 160 may determine that the insulation status of the battery pack 10 is an insulation breakdown.

The MCU 160 may finally output the insulation status diagnosis result (S1060). The MCU 160 may output insulation breakdown of the inverter 210 and insulation breakdown of the battery pack 10 as the insulation status diagnosis result.

Meanwhile, the MCU 160 may repeat steps S816 to S826, S902 to S906, S1010 to S1060 using the voltage V1 of the first insulation resistance monitoring terminal TR1, the voltage V2 of the second insulation resistance monitoring terminal TR2, the voltage V3 of the third insulation resistance monitoring terminal TR3, and the voltage V4 of the fourth insulation resistance monitoring terminal TR3 received from the first to fourth insulation resistance monitoring circuits 110 to 140 while the first relay 20 and the second relay 30 are maintained in the on state.

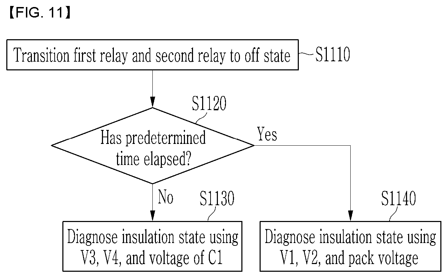

FIG. 11 is a flowchart illustrating an insulation state diagnosis method when the first relay and the second relay transition from an on state to an off state according to an embodiment.

Referring to FIG. 11, when the first relay 20 and the second relay 30 transition to the off state (S1110), the MCU 160 determines whether a predetermined time has elapsed after the first relay 20 and the second relay 30 transitioned to the off state (S1120).

The MCU 160 may receive the voltage V3 of the third insulation resistance monitoring terminal TR3 during the predetermined time after the first relay 20 and the second relay 30 transition to the off state.

The MCU 160 may diagnose the insulation state using the voltage V3 of the third insulation resistance monitoring terminal TR3, the voltage V4 of the fourth insulation resistance monitoring terminal TR4, and the voltage charged in the capacitor C1 during the predetermined time after the first relay 20 and the second relay 30 transition to the off state (S1130).

The step S1130 of diagnosing the insulation state using the voltage V3 of the third insulation resistance monitoring terminal TR3, the voltage V4 of the fourth insulation resistance monitoring terminal TR4, and the voltage charged in the capacitor C1 may include the steps S816 to S826, S902 to S906, and S1010 to S1060 described in FIGS. 8 to 10.

When the predetermined time has elapsed after the first relay 20 and the second relay 30 transitioned to the off state, the MCU 160 may diagnose the insulation state between the positive terminal P+ of the battery pack 10 and the ground terminal and the insulation state between the ground terminal and the negative terminal P- of the battery pack 10 using the voltage V1 of the first insulation resistance monitoring terminal TR1, the voltage V2 of the second insulation resistance monitoring terminal TR2, and the pack voltage V_{pack} (S1140).

The step S1140 of diagnosing the insulation state between the positive terminal P+ of the battery pack 10 and the ground terminal and the insulation state between the ground terminal and the negative terminal P- of the battery pack 10 using the voltage V1 of the first insulation resistance monitoring terminal TR1, the voltage V2 of the second insulation resistance monitoring terminal TR2, and the pack voltage V_{pack} may include the steps S812 and S814 of FIG. 8.

Although the embodiments of the present invention have been described in detail above, the scope of the present invention is not limited thereto, and various modifications and improvements made by those skilled in the art using the basic concept of the present invention as defined in the following claims also fall within the scope of the present invention.

## Claims

1. A battery system comprising:
a battery pack connected to a load of an external device;
a first insulation resistance monitoring circuit configured to include a first resistor, a first switch, and a second resistor connected in series between a positive terminal of the battery pack and a ground terminal, and to provide a first voltage divided by the first resistor and the second resistor;
a second insulation resistance monitoring circuit configured to include a first DC voltage source, a third resistor, a second switch, and a fourth resistor connected in series between the ground terminal and a negative terminal of the battery pack, and to provide a second voltage divided by the third resistor and the fourth resistor;
a first relay positioned between the positive terminal of the battery pack and a first terminal of the load;
a second relay positioned between the negative terminal of the battery pack and a second terminal of the load;
a first capacitor connected between the first terminal of the load and the second terminal of the load;
a third insulation resistance monitoring circuit configured to include a fifth resistor, a third switch, and a sixth resistor connected in series between the first terminal of the load and the ground terminal, and to provide a third voltage divided by the fifth resistor and the sixth resistor;
a fourth insulation resistance monitoring circuit configured to include a second DC voltage source, a seventh resistor, a fourth switch, and an eighth resistor connected in series between the ground terminal and the second terminal of the load, and to provide a fourth voltage divided by the seventh resistor and the eighth resistor; and
a main control unit (MCU) configured to diagnose an insulation state of the load using the third voltage and the fourth voltage, and to diagnose an insulation state of the battery pack using the first voltage and the second voltage.

2. The battery system according to claim 1, further comprising:
a second capacitor connected between the first terminal of the load and the ground terminal; and
a third capacitor connected between the ground terminal and the second terminal of the load,
wherein, in an on-state of the first relay and the second relay, the MCU diagnoses the insulation state of the load using the third voltage and the fourth voltage;
when the insulation state of the load is determined to be a symmetric insulation breakdown, the MCU diagnoses the insulation state of the battery pack using the first voltage and the second voltage; and
when the insulation state of the battery pack is determined to be an insulation breakdown, the MCU transitions the first relay and the second relay to an off-state, turns on the third switch and the fourth switch, and discharges the second capacitor and the third capacitor.

3. The battery system according to claim 2, wherein
the MCU measures a first insulation resistance formed between the first terminal of the load and the ground terminal and a second insulation resistance formed between the ground terminal and the second terminal of the load using the third voltage and the fourth voltage, and when both the first insulation resistance and the second insulation resistance are less than a reference value, the MCU determines the insulation state of the load to be the symmetric insulation breakdown.

4. The battery system according to claim 3, wherein
when the insulation state of the load is determined to be an asymmetric insulation breakdown, the MCU transitions the first relay and the second relay to the off-state, turns on the third switch and the fourth switch, discharges the second capacitor and the third capacitor, and re-diagnoses the insulation state of the load using the third voltage and the fourth voltage.

5. The battery system according to claim 4, wherein
when the insulation state of the load according to the re-diagnosis is an asymmetric insulation breakdown, the MCU diagnoses the insulation state of the battery pack using the first voltage and the second voltage, and diagnoses a final insulation breakdown based on the insulation state of the battery pack.

6. The battery system according to claim 4, wherein
the MCU determines the insulation state of the load as the asymmetric insulation breakdown when either the first insulation resistance or the second insulation resistance is less than the reference value.

7. The battery system according to claim 1, wherein
the MCU periodically performs an operation of simultaneously turning on the first and third switches and simultaneously turning on the second and fourth switches to periodically receive the first voltage, the second voltage, the third voltage, and the fourth voltage.

8. The battery system according to claim 1, wherein
the MCU periodically performs an operation of turning on the first switch, the second switch, the third switch, and the fourth switch one by one for a predetermined period to periodically receive the first voltage, the second voltage, the third voltage, and the fourth voltage.

9. An insulation resistance measurement apparatus of a battery management system for managing a battery pack connected to a load of an external device, the apparatus comprising:
a first monitoring circuit configured to measure a first voltage divided by a first resistor and a second resistor connected in series between a positive terminal of the battery pack and a ground terminal, and a second voltage divided by a third resistor and a fourth resistor connected in series between the ground terminal and a negative terminal of the battery pack;
a first relay connected between the positive terminal of the battery pack and a positive connection terminal of the battery pack connected to a first terminal of the load;
a second relay connected between the negative terminal of the battery pack and a negative connection terminal of the battery pack connected to a second terminal of the load;
a first capacitor connected between the first terminal of the load and the second terminal of the load;
a second monitoring circuit configured to measure a third voltage divided by a fifth resistor and a sixth resistor connected in series between the positive connection terminal of the battery pack and the ground terminal, and a fourth voltage divided by a seventh resistor and an eighth resistor connected in series between the ground terminal and the negative connection terminal of the battery pack; and
a main control unit (MCU) configured to measure a first insulation resistance formed between the positive terminal of the battery pack and the ground terminal and a second insulation resistance formed between the ground terminal and the negative terminal of the battery pack using the first voltage and the second voltage, and to measure a third insulation resistance formed between the first terminal of the load and the ground terminal and a fourth insulation resistance formed between the ground terminal and the second terminal of the load using the third voltage and the fourth voltage.

10. The insulation resistance measurement apparatus according to claim 9, wherein
the first monitoring circuit further comprises:
a first switch connected between the positive terminal of the battery pack and the ground terminal on a path formed by the first resistor and the second resistor; and
a first DC voltage source and a second switch connected between the ground terminal and the negative terminal of the battery pack on a path formed by the third resistor and the fourth resistor,
wherein the second monitoring circuit further comprises:
a third switch connected between the positive connection terminal of the battery pack and the ground terminal on a path formed by the fifth resistor and the sixth resistor; and
a second DC voltage source and a fourth switch connected between the ground terminal and the negative connection terminal of the battery pack on a path formed by the seventh resistor and the eighth resistor, and
wherein, in an on-state of the first relay and the second relay, the MCU diagnoses an insulation state of the load based on the third insulation resistance and the fourth insulation resistance,
when the insulation state of the load is determined to be a symmetric insulation breakdown, the MCU diagnoses an insulation state of the battery pack based on the first insulation resistance and the second insulation resistance, and
when the insulation state of the battery pack is determined to be an insulation breakdown, the MCU transitions the first relay and the second relay to an off-state, turns on the third switch and the fourth switch, and discharges a second capacitor connected between the first terminal of the load and the ground terminal and a third capacitor connected between the ground terminal and the second terminal of the load.

11. The insulation resistance measurement apparatus according to claim 10, wherein
the MCU measures a voltage of the battery pack, determines a reference value for insulation state diagnosis based on the voltage of the battery pack, and determines the insulation state of the load as the symmetric insulation breakdown when both the third insulation resistance and the fourth insulation resistance are less than the reference value.

12. The insulation resistance measurement apparatus according to claim 11, wherein
when the insulation state of the load is determined to be an asymmetric insulation breakdown, the MCU transitions the first relay and the second relay to the off-state, turns on the third switch and the fourth switch, discharges the second capacitor and the third capacitor, and re-diagnoses the insulation state of the load using the third voltage and the fourth voltage.

13. The insulation resistance measurement apparatus according to claim 12, wherein
when the insulation state of the load according to the re-diagnosis is an asymmetric insulation breakdown, the MCU diagnoses the insulation state of the battery pack using the first voltage and the second voltage, and diagnoses a final insulation breakdown based on the insulation state of the battery pack.

14. The insulation resistance measurement apparatus according to claim 13, wherein
the MCU determines the insulation state of the load as the asymmetric insulation breakdown when either the third insulation resistance or the fourth insulation resistance is less than the reference value.

15. The insulation resistance measurement apparatus according to claim 10, wherein
the MCU periodically performs an operation of simultaneously turning on the first and third switches and simultaneously turning on the second and fourth switches to periodically receive the first voltage, the second voltage, the third voltage, and the fourth voltage.

16. The insulation resistance measurement apparatus according to claim 10, wherein
the MCU periodically performs an operation of turning on the first switch, the second switch, the third switch, and the fourth switch one by one for a predetermined period to periodically receive the first voltage, the second voltage, the third voltage, and the fourth voltage.
